# EUROPEAN PATENT APPLICATION

(11) **EP 3 330 634 A1**
(43) Date of publication of application: **06.06.2018**
(21) Application number: 15899253.7
(22) Date of filing: 29.07.2015
(51) Int. Cl.: F24J 2/07, F24J 2/10

(54) **ENCLOSED SOLAR ENERGY UTILIZATION DEVICE AND SYSTEM**

(71) Applicant: Bolymedia Holdings Co. Ltd., Santa Clara, California 95051 (US)
(72) Inventor: HU, Xiaoping, Shenzhen Guangdong 518055 (CN)
(74) Representative: Manitz Finsterwald Patentanwälte PartmbB
(86) International application number: PCT/CN2015/085442
(87) International publication number: WO 2017/015901

(57) **Abstract**

Disclosed is an enclosed solar energy utilization device and system. The device comprises a first receiver (110), which forms a relatively enclosed first cavity (111) with at least one light inlet (112) arranged thereon; at least one light energy conversion element (102) arranged on the inner wall or in the inner space of the first cavity (111); and at least one light guide device (104), each of which is hermetically fitted to the corresponding light inlet (112), in order to guide the externally collected sunlight to enter the first cavity (111) through the light inlet (112). The sunlight is guided into the relatively enclosed cavity, and is not be diffused once the sunlight has touched the light energy conversion element (102). Therefore, the efficiency of the conversion can be improved.

## Description

### FIELD

The present disclosure relates to the technical field of clean energy, and more particularly to an enclosed solar energy utilization apparatus and system for utilizing solar energy.

### BACKGROUND

As environmental protection has been valued increasingly highly, solar energy systems have been applied more and more widely. Current solar energy systems in use mostly have two aspects of problems: firstly, limitations of environmental conditions result in that solar energy can only be collected in restricted time and space; secondly, restricted by current technical levels, light energy conversion elements (e.g., photovoltaic panels) generally have an unsatisfactory conversion efficiency, such that most of the collected sunlight, which is originally limited, will be diffused without energy conversion after contacting once with the light energy conversion elements. The diffused sunlight will always become a light pollution.

Therefore, it is desirable to develop a solar energy utilization apparatus that may improve solar energy conversion efficiency.

### SUMMARY

One aspect according to the present disclosure provides an enclosed solar energy utilization apparatus, comprising: a first receiver that forms a relatively enclosed first cavity on which at least one light inlet is provided; at least one light energy conversion element, or at least one light energy conversion element and at least one light reflection element, which is(are) provided on an inner wall of the first cavity or provided inside an internal space of the first cavity; and at least one light guide device each being hermetically-fitted to the corresponding light inlet, for guiding externally collected sunlight to enter the first cavity via the light inlet.

Another aspect of the present disclosure provides a solar energy utilization system, comprising the enclosed solar energy utilization apparatus as mentioned above and a first circulating system, wherein the first cavity is further provided with at least one working medium inlet for allowing a first working medium to enter the first cavity and at least one first product outlet for allowing a first product to leave the first cavity into the first circulating system, the first product being a substance obtained after at least part of energy from sunlight acts on the first working medium. The first circulating system is an open or enclosed circulating system, comprising: a first pipeline system that is at least connected with the first product outlet, or at least connected with the first working medium inlet and the first product outlet; at least one valve for controlling switch-on and switch-off of a segment of pipeline in the first pipeline system; and at least one node device connected into the first pipeline system, for storing, or for energy conversion, or for energy exchange.

A further aspect of the present disclosure provides a solar energy utilization system, comprising the first receiver and the first circulating system as mentioned above, and further comprising a second receiver and a second circulating system, wherein the second receiver is formed as a relatively enclosed second cavity on which at least one light inlet is provided; the second receiver is at least partially provided inside an internal space of the first cavity; at least one light energy conversion element is provided on an inner wall of the second cavity or provided inside an internal space of the second cavity; and at least one light guide device is through the light inlet of the first cavity and hermetically-fitted with the light inlet of the second cavity, for guiding externally collected sunlight into the second cavity. At least one second working medium inlet and at least one second product outlet are further provided on the second cavity. The second circulating system is an open or enclosed circulating system, comprising: a second pipeline system that is at least connected with a second product outlet, or at least connected with the second working medium inlet and the second product outlet; at least one valve for controlling switch-on and switch-off of a segment of pipeline in the second pipeline system; and at least one node device connected into the second pipeline system, for storing, or for energy conversion, or for energy exchange.

The enclosed solar energy utilization apparatus according to the present disclosure guides, using a light guide device, collected sunlight into a relatively enclosed cavity such that the sunlight will not be diffused upon contacting once with the light energy conversion element; instead, the sunlight is converted into a usable thermal energy in the cavity or is reflected again or for more times to contact with the light energy conversion element to improve the efficiency of directly converting the sunlight (e.g., converted into an electric energy), thereby capable of utilizing the collected limited solar energy as sufficiently as possible.

The solar energy utilizing system according to the present disclosure connects the enclosed solar energy utilization apparatus to the circulating system, such that the working medium of the circulating system participates in sunlight absorption and conversion inside the working cavity of the enclosed solar energy utilization apparatus; in this way, the energy from the sunlight may be utilized more sufficiently, and more functions may be provided, e.g., through the circulating system, the solar energy may be converted into other usable energies, e.g., kinetic energy provided by steam or chemical energy that is available for long-term storage.

Hereinafter, specific examples according to the present disclosure will be described in detail with reference to the accompanying drawings.

### BRIEF DESCRIPTION OF THE DRAWINGS

FIG. 1 is a schematic diagram of an enclosed solar energy utilization apparatus according to Embodiment 1;
FIG. 2 is a schematic diagram of two kinds of coaxial planes for generating a Fresnel refracting surface in the present disclosure;
FIG. 3 is a schematic diagram of a light-converging device having two toothed surfaces in the present disclosure;
FIG. 4 is a schematic diagram of an enclosed solar energy utilization apparatus of Embodiment 2;
FIG. 5 is a schematic diagram of an enclosed solar energy utilization apparatus of Embodiment 3;
FIG. 6 is a schematic diagram of an enclosed solar energy utilization system of Embodiment 4;
FIG. 7 is a schematic diagram of an enclosed solar energy utilization system of Embodiment 5;
FIG. 8 is a schematic diagram of an enclosed solar energy utilization system of Embodiment 6; and
FIG. 9 is a schematic diagram of an enclosed solar energy utilization system of Embodiment 7.

### DETAILED DESCRIPTION OF EMBODIMENTS

Embodiment 1

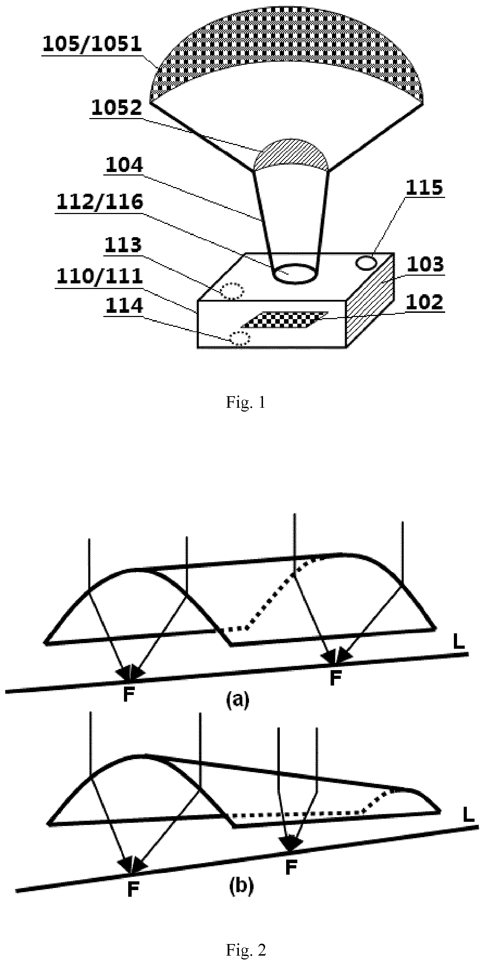

Fig. 1 shows an embodiment of an enclosed solar energy utilization apparatus according to the present disclosure, comprising a first receiver 110, a light energy conversion element 102, a light reflection element 103, a light guide device 104, and a light converging device 105.

The first receiver 110 is formed as a relatively enclosed first cavity 111 on which a light inlet 112 is provided. The "relatively enclosed" herein means that sunlight incident into the cavity and a substance present in the cavity will not be freely diffused. On one hand, the sunlight entering the cavity via the light inlet will not penetrate through a wall of the cavity to be diffused away from the cavity, e.g., the cavity is made of a light reflecting material. On the other hand, the substance present in the cavity is either completely enclosed inside the cavity or communicates with the external in a controllable way, e.g., communicating with the external via a pipeline with a valve; due to the controllability of communication, this will not compromise the meaning of "relative enclosed" cavity.

The light conversion element 102 in this embodiment is of a sheet shape, which may be regarded as being disposed on an inner wall of the first cavity or regarded as being provided inside an internal space of the first cavity. The light energy conversion element is a functional element (e.g., a photovoltaic panel) for converting sunlight into other energy, and electric energy generated thereby is led out from the cavity via a circuit (not shown in the figure). One or more light energy conversion elements may be provided according to needs. The light energy conversion element(s) may adopt a sheet shape, laid out on the inner wall of the cavity or provided inside the internal space of the cavity; besides, a support structure of the light energy conversion element is formed into a stereoscopic shape, e.g., a cuboid, a hexahedron, a sphere, and an ellipsoid, etc.; in this case, the light conversion element is disposed on an outer surface of the support structure, e.g., laid out on the entire outer surface of the support structure.

The light reflection element 103 in the present embodiment is disposed on the inner wall of the first cavity; one or more light reflecting elements may be provided according to needs. In other embodiments, the light reflection element may also be disposed inside the internal space of the cavity according to needs. The light reflection element may also be manufactured by coating or adhering a reflective material to the inner wall. In other embodiments, because the light energy conversion element usually also has a certain reflectivity, a specific light reflection element might not be provided. As a preferred embodiment, the light energy conversion element or the light reflection element may be laid out on the entire inner wall of the first cavity, such that on one hand, the sunlight may be properly sealed, and on the other hand, the sunlight conversion efficiency may be sufficiently improved. When the light energy conversion element is provided stereoscopically inside the internal space of the cavity, the light reflection element may be laid out on the entire inner wall of the cavity.

In this embodiment, the first cavity is further provided with a first working medium inlet 113 and two first product outlets 114, 115. The first working medium inlet is configured for allowing a first working medium into the first cavity, and the first product outlet is configured for allowing the first product to leave the first cavity into an externally connected circulating system, the first product being a substance obtained after at least part of energy from sunlight acts on the first working medium. For example, the first product may be a first working medium heated by heat generated by the light energy conversion element; if the temperature for heating is high enough, the first product may also comprise a phase-changed first working medium, and the first product may also be a product resulting from electrolyzing the first working medium by an electric energy generated by the photovoltaic panel; or, if a plurality of first working mediums are simultaneously mixed into the first cavity, the first product may also be a product resulting from chemical combination of these mixtures under a high temperature. The numbers of inlets and outlets may be set according to needs, e.g., setting according to the numbers of kinds of the working mediums and products.

In this embodiment, the first working medium is fresh water or seal water; and the first product has two kinds: one being heated water, which may be obtained via an outlet 114 disposed at a lower portion of the cavity; the other being gasified water steam, which may be obtained via an outlet 115 disposed at a top portion of the cavity. If the first working medium is fresh water, the present apparatus may be used as a hot water generating apparatus; if the first working medium is seal water, the present apparatus may function to desalinize the sea water, such that the water steam obtained at the outlet 115 is fresh water upon condensation, while the outlet 114 may function as a drainage outlet for draining seal water remnants (including salt slags). To prolong a service life of the cavity, the inner wall of the cavity may be subject to water-proof and anti-corrosion processing. To avoid energy diffusion, an outer surface of the cavity may be wrapped with a thermal insulation material.

In other embodiments, the first cavity may only have one first product outlet, e.g., only having a hot water outlet or a water steam outlet. In other embodiments, other kinds of the first working medium may also be selected according to needs, e.g., alcohol, refrigerant (Freon, etc.), and liquid nitrogen. In other embodiments, the first cavity may also be completely enclosed, such that the converted energy is only outputted by the light energy conversion element, wherein the cavity may be filled with or without mediums. In this case, for the purpose of heat dissipation or heat reuse, part or all of the first cavity is dipped inside an open or enclosed liquid pool, e.g., a reservoir, a lake, a river, a sea, or a water tank of a hot water supply system, etc.

The light guide device 104 is hermetically-fitted with the corresponding light inlet 112, for guiding the externally collected sunlight into a first cavity via the light inlet. The light guide device may be manufactured according to various kinds of existing light transmission technologies, e.g., it may be manufactured using a solid transparent material or a hollow pipeline, with a reflective film coated on an external surface or an inner surface thereof, such that the sunlight may only advance to the light inlet and irradiate into the cavity after entering the light guide device.

In this embodiment, the enclosed solar energy utilization apparatus 116 further comprises a divergent lens 116 provided at the light inlet 112. With the divergent lens, the sunlight entering the light inlet may be diverged to avoid the sunlight from being reflected back after irradiating onto a wall (e.g., a photovoltaic panel or a reflective mirror) facing the light inlet. Specifically, the divergent lens may be designed, integrally with the light inlet 112, to be mounted on the cavity; or designed, integrally with a light path outlet of the light guide device, to be mounted on the light guide device. The sunlight irradiates on for example the photovoltaic panel in a divergent conical shape after passing through the divergent lens; in this way, the light reflected by the photovoltaic panel may be utilized for multiple times by disposing a reflective mirror at a periphery of the photovoltaic panel. In other embodiments, a divergent lens may not be used; instead, diffusion of the sunlight from the light inlet may be reduced or avoided in other ways, e.g., the light guide device may be inserted into an appropriate depth in the cavity, or a light exit direction of the light guide device may be angled with a normal direction of the inner wall it faces. These different ways may be used in coordination.

The light converging device 105 is configured for converging sunlight to a light path inlet of the corresponding light guide device. The light converging device has at least one light converging refractive surface which may have a relatively large area to receive more sunlight. In this embodiment, two light converging refractive surfaces 1051, 1052 sequentially arranged along a light path direction are provided to achieve a stronger converging effect. In addition, the light converging refractive surfaces (or the other face of the optical element where the refractive surfaces are disposed) may also be coated with a film for enhancing transmissivity, to thereby reduce reflection loss of the sunlight in the light converging device and enhance light converging efficiency.

This embodiment schematically illustrates a light inlet, and a light guide device and a light converging device that correspond to the light inlet. In other embodiments, the first cavity may also be provided with a plurality of light inlets, and a plurality of light guide devices and light converging devices that correspond to the plurality of light inlets. In this case, a position of the light inlet should be cautiously disposed such that the sunlight incident from one light inlet is not easily diffused from another light inlet. Or, a light guide device having a plurality of inlets and a single outlet may be configured such that sunlight converged by the plurality of light converging devices is incident from one outlet into the cavity.

As a preferred embodiment, the light converging refractive surface may adopt a toothed surface provided by a Fresnel lens. To facilitate understanding, a relevant concept will be introduced *infra.*

The Fresnel lens is a thinned lens. The Fresnel lens is formed by cutting a continuous original curved surface of a typical lens into a plurality of sections, and after the thickness of each section is reduced, disposing each section of the curved surface in a same plane or on a same substantially smooth curved surface. A discontinuous refractive surface evolved from the original curved surface may be referred to as a Fresnel refracting surface, generally of a stepped or toothed shape. Theoretically, the Fresnel refracting surface has an approximate optical performance compared with the corresponding original curved surface, but with a significantly reduced thickness. The Fresnel refracting surface generated by an original curved surface (or part of the original curved surface) may be referred to as a Fresnel unit.

A conventional original curved surface for generating the Fresnel refracting surface is typically a curved surface symmetrical about an optical axis, e.g., a spherical surface, and a rotational curved surface such as a rotating paraboloid. Focuses of the conventional original curved surface are at a common point, which thus may be referred to as "a concurrent plane." In the present disclosure, the original curved surface may be a coaxial surface in any fashion, which may be specifically arranged according to application needs. The alleged coaxial surface refers to a curved surface whose focuses are on a same straight line (but not necessarily at the same point); this straight line may be referred to as a "coaxial line." A traditional concurrent plane may be regarded as a specific example where the coaxial line of the coaxial surface is reduced to one point. By adopting an original curved surface that is coaxial but not concurrent, a sensing element disposed at a focusing position may be extended from a smaller area (corresponding to a focus) into an elongated shape (corresponding to the coaxial line formed by focuses), such that without significantly increasing costs, the capacity of signal collection is enhanced, which facilitates solving the problem of locally overheating. A typical coaxial plane includes a rotational curved surface (including a secondary or high-order rotational curved surface), a column surface, and a conical surface, etc., wherein the column surface may also be referred to as a uniform-section coaxial surface; by cutting open this curved surface at any point along a vertical direction of the coaxial line, the shapes and sizes of the resulting cross sections are all identical; therefore, a cylindrical surface is only a specific example of the column surface. Cross sections of a conical surface along the coaxial line have similar shapes but different sizes; therefore, a circular conical surface is only a specific example of the conical surface. Fig. 2 shows the above two kinds of coaxial planes, wherein Fig. 2(a) shows a uniform-section coaxial plane, and Fig. 2(b) shows a conical coaxial plane, with their respective focuses F being all located on their respective coaxial lines L.

A macroscopic refractive surface composed of one or more Fresnel units may be referred to as a toothed surface, while a substantially smooth or flat surface opposite thereto may be referred to as a back surface. A toothed surface only containing one Fresnel unit may be referred to as a "simple Fresnel refracting surface," while a toothed surface containing two or more Fresnel units is referred to as a "complex Fresnel refracting surface." Generally, basic parameters (e.g., area, focal length, shape of the corresponding original curved surface, and the number of concentric circles used when dividing the original curved surface, etc.) of respective Fresnel units on the complex Fresnel refracting surface may be flexibly arranged, i.e., they may be completely identical, partially identical or completely different. In one embodiment, each Fresnel unit on the complex Fresnel refracting surface has its own optical center; but their focuses fall on a same point, or on a same straight line, or into a limited region. This may be implemented by spatial arrangement of each Fresnel unit constituting the complex Fresnel refracting surface. It may be regarded that these Fresnel units are arranged on a macroscopic curved surface, e.g., a planar surface, a quadric surface (including a spherical surface, an ellipsoidal surface, a cylindrical surface, a parabolic cylindrical surface, a hyperbolic cylindrical surface), a high-order polynomial surface (a general implementation of a non-spherical surface), and a folded face or stepped surface spliced by a plurality of planar surfaces, etc.

The toothed surface and the back surface may be flexibly combined to form different types of elements. For example, a Fresnel lens having one toothed surface and one back surface may be referred as a "single-surface Fresnel lens." Further, if the toothed surface is a "simple Fresnel refracting surface," then the lens is a "single-surface simple Fresnel lens"; if the toothed surface is a "complex Fresnel refracting surface," then the lens is a "single-surface complex Fresnel lens." A Fresnel lens with both surfaces being toothed surfaces may be referred to as a "double-surface Fresnel lens," which may also be further differentiated into "a double-surface simple Fresnel lens" and a "double-surface complex Fresnel lens." If one toothed surface of the double-surface Fresnel lens is a simple Fresnel refracting surface, while the other toothed surface is a complex Fresnel refracting surface, such a Fresnel lens may be referred to as a "double-surface mixed Fresnel lens." Besides, as a variation, in the double-surface Fresnel lens, if one of the toothed surfaces is the "simple Fresnel refracting surface," the toothed surface may be replaced by a traditional convex mirror surface or a concave mirror surface.

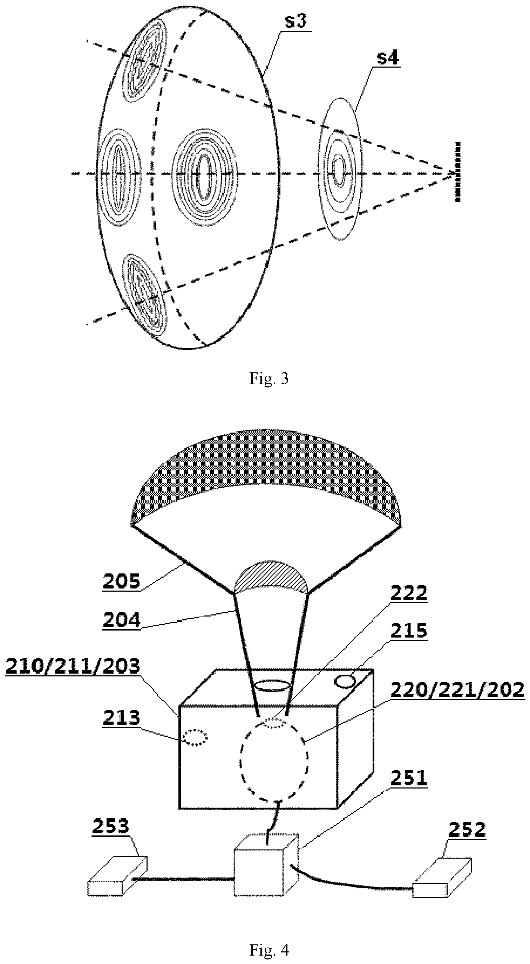

By disposing two or more toothed surfaces on a same optical path, the light converging device may have a better converging capability. Fig. 3 shows a light converging device having two toothed surfaces, wherein the complex Fresnel refracting surface s3 and the simple Fresnel refracting surface s4 may be both provided by one double-surface Fresnel lens or separately provided by two single-surface Fresnel lenses.

The light converging device and the divergent lens herein may use a Fresnel lens hat has a convex mirror or concave mirror optical characteristics or a combination of such Fresnel lenses.

The reflective mirror is usually obtained by coating a reflective film on a material such as glass and plastics; while the reflective film and the film on the light converging refractive surface for enhancing transmissivity are usually metal films. According to a photoelectric effect, free electrons will be generated when light irradiates on the metal film. Therefore, when the light energy conversion element is a photovoltaic panel, the metal film on the reflective mirror or the light converging refractive surface will be electrically connected with a negative pole of the photovoltaic panel, e.g., in direct serial connection or parallel connection, or in serial connection or parallel connection via a capacitor, thereby achieving the objective of improving photo-electric conversion efficiency and eliminating static electricity.

With the enclosed solar energy utilization apparatus of the present embodiment, on one hand, the solar energy will be converged into an enclosed cavity, energy of which is substantially all converted into thermal energy or electric energy, thereby being utilized sufficiently; on the other hand, by introducing water into the cavity to generate hot water and water steam, the solar energy not converted into the electric energy may be absorbed and utilized by thermal energy or by other means, thereby achieving more functions, e.g., providing hot water, or realizing sea water desalinization, or performing secondary power generation using water steam.

In addition, because elements such as the photovoltaic panel and the reflective mirror are both enclosed inside the cavity, no light pollution will be generated, and no adverse effect will be created to the surrounding ecological environment. In contrast, the existing conventional large-scale solar energy power stations not only have a relatively low conversion efficiency, but also cause a very large light pollution; besides, exposed photovoltaic panels will frequently kill birds and insects, which not only compromises the environment but also incurs additional cleaning demands.

### Embodiment 2

Fig. 4 illustrates another embodiment of an enclosed solar energy utilization apparatus according to the present disclosure, comprising a first receiver 210, a light energy conversion element 202, a light reflection element 203, a light guide device 204, a light converging device 205, and a second receiver 220.

Components in this embodiment and the following embodiments, which are identically termed as those in Embodiment 1, may refer to the description in Embodiment 1 unless otherwise indicated, which thus will not be detailed here.

The first receiver is formed as a relatively enclosed first cavity 211 on which a first working medium inlet 213 and a first product outlet 215 are provided, wherein the first working medium is water, and the outlet 215 is a water steam outlet. the light reflection element 203 is laid out on the entire inner wall of the first cavity.

The second receiver 220 is formed as a second cavity 221 on which a light inlet 222 is provided. The light guide device 204 is through a light inlet (not shown) of the first cavity and fitted to the light inlet of the second cavity, for guiding externally collected sunlight to at least partially enter the second cavity. In this embodiment, an interstice exists between a light path outlet of the light guide device and the light inlet of the second cavity such that part of the sunlight enters the first cavity and the other part enters the second cavity. This case may be regarded that the first cavity and the second cavity share one light guide device. In other embodiments, the light guide device may also be hermetically fitted with the light inlet of the second cavity such that the sunlight all enters the second cavity, which also makes the second cavity enclosed relatively; in this case, the first cavity may be separately configured with a light guide device and/or a light converging device for its use.

The light energy conversion element 202 is disposed on an inner wall of the second cavity, corresponding to being disposed inside the internal space of the first cavity. In other embodiments, the light energy conversion element may also be disposed inside an internal space of the second cavity. As a preferred embodiment, the light energy conversion element may be laid out at the entire inner wall of the second cavity, and the light energy conversion element or light reflection element may be laid out on an entire outer wall of the second cavity.

In this embodiment, the second receiver is completely disposed in the internal space of the first cavity. In other embodiments, the second receiver may also be partially disposed in the internal space of the first cavity while the remaining part passes out of the first cavity according to needs, wherein the part of the second receiver passing out of the first cavity needs to be hermetically fitted to the first cavity.

In this embodiment, at least one light energy conversion element is a photovoltaic panel. To better store and utilize the electric energy converted from the solar energy, this embodiment further includes additional elements listed below (in other embodiments, any one or more components that may generate an electric energy may be selected according to application needs):

An energy store 251 electrically connected with a component that generates electric energy (e.g., photovoltaic panel 202) via a wire, for storing the electric energy. The energy store may be selected from a supercapacitor, a rechargeable battery, and an air compressor. The energy store may directly supply DC (Direct Current) outputs at various voltages to users through a connected DC voltage output device 252.

An AC inverter 253 electrically connected with the energy store (in other embodiments, it may also be directly electrically connected with the photovoltaic panel), for converting the DC outputted by the photovoltaic panel into alternative current(AC), e.g., a 60 HZ 120 v or 50Hz 220V, which may not only directly supply AC output to the users, but also may be externally connected to a networked switch cabinet to feed the electric energy back to the grid.

A state sensor and a state display (not shown in the figure) for sensing and displaying operating parameters, respectively. These operating parameters may be selected from one or more of the following set: voltage, current, power, stock and temperature of the working medium in the cavity, etc.

A controller for controlling a working state of the apparatus based on a sensing result of the state sensor. For example, controlling power-on or off of the entire apparatus; automatically alarming when parameter abnormalities are detected, etc. With the controller, an operating state-based automatic control may be implemented, which facilitates expanding a use scope of the solar energy utilization apparatus.

### Embodiment 3

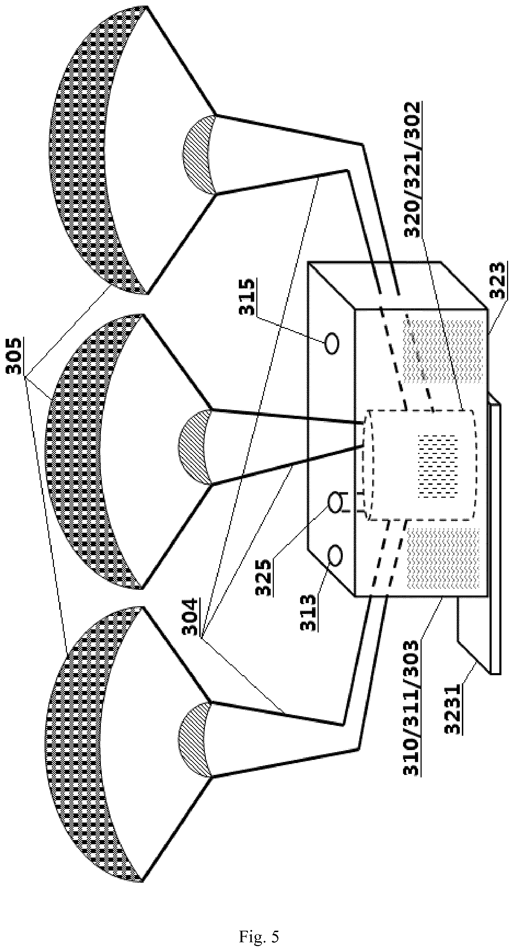

Fig. 5 illustrates a further embodiment of an enclosed solar energy utilization apparatus according to the present disclosure, comprising: a first receiver 310, a light energy conversion element 302, a light reflection element 303, a light guide device 304, a light converging device 305, and a second receiver 320.

Components mentioned in this embodiment and the following embodiments, which are identically termed as those first appearing in Embodiment 2, may refer to the description in Embodiment 2 unless otherwise indicated, which thus will not be detailed here.

The first receiver is formed as a relatively enclosed first cavity 311 on which a first working medium inlet 313 and a first product outlet 315 are provided.

The second receiver 320 is formed as a relatively enclosed second cavity 321 on which three light inlets (not shown) are provided. Three light guide devices 304 are through three light inlets (not shown) of the first cavity and hermetically fitted to the light inlets of the second cavity, for guiding externally collected sunlight to enter the second cavity. In this embodiment, three light converging devices 305 are correspondingly provided.

In this embodiment, the second cavity is further provided with a second working medium inlet 323 for allowing the second working medium to enter the second cavity and a second product outlet 325 for allowing the second product to leave the second cavity into an externally connected circulating system, the second product being a substance obtained after at least part of energy from the sunlight acts on the second working medium. Similar to the relationship between the first working medium and the first product, the second product may be a heated second working medium or a gasified second working medium or a product from decomposition or chemical combination of the second working medium. To prolong the service life of the cavity, an inner wall of the cavity may be subject to waterproof and anti-corrosion processing.

The first working medium and the second working medium may be selected to be of identical or different kinds. When different kinds of working mediums are selected, the first cavity and the second cavity may be externally connected to different circulating systems to implement different functions. When the working mediums are selected to be of the same kind, the circulating systems externally connected with the first cavity and the second cavity may be the same circulating system or mutually communicating circulating systems so as to implement a concentrated large power.

In this embodiment, a bottom portion of the second cavity passes out of the first cavity, such that the second working medium inlet 323 is formed as an openable opening which may be closed or opened through an openable door 3231. The openable opening may act as a cleaning and maintenance opening of the second cavity; therefore, its dimension may be designed to be relatively large so as to facilitate cleaning and maintenance operations. In other embodiments, the second product outlet may also be formed as an openable opening; or an independent openable opening may be provided for cleaning and maintenance, which openable opening may be disposed at a side face or a bottom portion of the second cavity. Similarly, the openable opening for cleaning and maintenance may also be disposed at a side face or bottom portion of the first cavity; or, the first working medium inlet or the first product outlet may be formed into an openable opening.

The apparatus in this embodiment is applicable for building a large-scale solar power station, which may be constructed at a seashore or on an offshore; in this way, it not only saves land area but also obtains abundant solar energy. The second working medium adopts seal water. An outer surface of the first cavity may be subject to anti-corrosion, waterproof and heat insulation processing; then, the first receiver is directly dipped in the seal water. During working, the openable door 3231 is opened in a power-driven fashion, such that the seal water enters the second cavity with slags in the second cavity being removed simultaneously; then the door 3231 is sealed. In this way, the solar energy may be utilized to generate power and heat the seal water in the second cavity; further, water steam is obtained from the outlet 325, thereby achieving seal water desalinization. According to needs, the entire apparatus may be taken out from the sea water; after opening the door 3231, slags after seal water evaporation may be used as chemical raw materials. The first working medium in this embodiment may be selected according to the needs of the connected circulating system. For example, in the case of an externally connected enclosed circulating system, liquids like Freon and alcohol, which may be gasified under a relatively low temperature, may be adopted.

### Embodiment 4

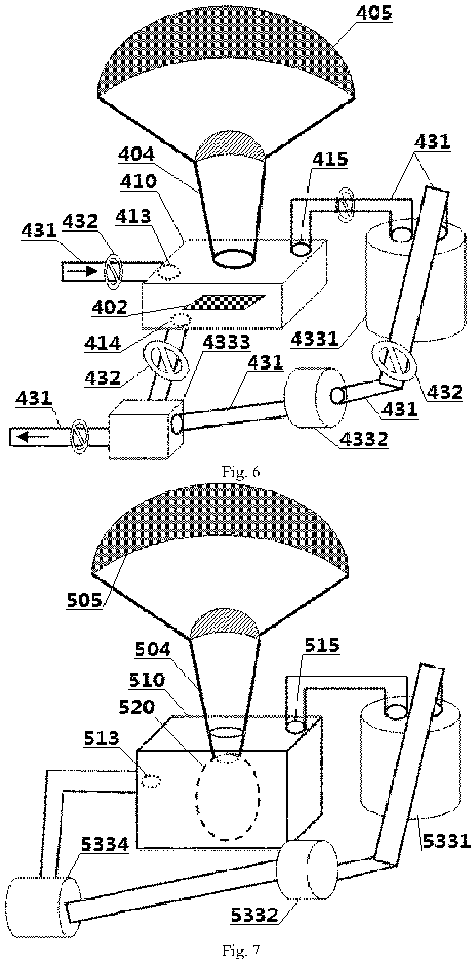

Fig. 6 illustrates an embodiment of a solar energy utilization system according to the present disclosure, comprising an enclosed solar energy utilization apparatus and a first circulating system.

The enclosed solar energy utilization apparatus in this embodiment has a structure similar to Embodiment 1, comprising a first receiver 410, a photovoltaic panel 402, a light reflection element (not shown), a light guide device 404, and a light converging device 405.

The first circulating system is an open circulating system. The "open" herein means that a working medium in the system is open-loop circulated. The working medium may flow out of the system and be supplemented from outside the system. For example, in the case of using water as the working medium, a system that introduces cold water from an external water supply system and supplies heated water to a user for use is an open circulating system; or, a system that electrolyzes water into hydrogen and oxygen to be released out is also a kind of open circulating system. In the open circulating system, the pipeline is not required to form a loop. The alleged "enclosed" means that the working medium in the system circulates in a closed-loop inside the system, which basically will not cause loss. For example, a system that causes a refrigerant as the working medium to be compressed inside the compressor to dissipate heat and then cause the refrigerant to expand at a heat exchanger to absorb heat is an enclosed circulating system. In the enclosed circulating system, the pipeline needs to form a loop. A circulating system may switch between an open type and an enclosed type. For example, in the case that a loop is formed by a pipeline, the system will change from an open type to an enclosed type by closing the valve for connecting the system to the outside.

The first circulating system comprises a first pipeline system consisting of a plurality of pipelines 431 (not completely shown), at least one valve 432 (not completely shown), and at least one node device.

In this embodiment, the first pipeline system is connected with one first working medium inlet 413 and two first product outlets (hot water outlet 414, water steam outlet 415), but does not constitute a loop. In other embodiments, the first pipeline system may be only connected with the first product outlet according to needs; and the first working medium may be supplemented into the first cavity in other fashion (e.g., through the openable opening). For the sake of brevity, the pipeline will not be specifically mentioned in the description infra; unless otherwise indicated, flowing of the working medium and the product is all performed through the pipeline.

In this embodiment, switch-on and switch-off of the pipelines in the first pipeline system are controlled by valves, each valve controlling one segment of pipeline; all or part of the pipelines may be configured with valves according to needs. For the sake of conciseness, valves disposed on the pipelines are all omitted in subsequent drawings. The valves may be automatic valves (for example, opening or closing of the valves is controlled by pressure in the pipelines); the valves may also be electrically controlled according to instructions from a control system. The adopted valves may also have a function of flow control.

A node device is connected in the first pipeline system, for storing, or for energy conversion, or for energy exchange. By configuring various kinds of node devices, rich functions may be implemented.

In this embodiment, the first working medium is a liquid (e.g., water), and the first product is water steam. The node devices include: a gas storage module 4331 for storing water steam, a (DC) steam turbo-generator 4332 for generating power using the water steam, and a working medium recovery module 4333 for recovering hot water after power generation. The respective node devices are arranged along a flow direction of water steam according to the above order starting from the outlet 415. In other embodiments, the types of node devices in use may also only include one or more in the above set. In addition, a same type of node devices may also be provided in plurality, e.g., a plurality of gas storage devices and steam turbo-generators may be arranged in series or in parallel according to the amount of generated water steam. The electric energy generated by the photovoltaic panel and the steam turbo-generator may be both connected to the energy store described in Embodiment 2 or directly supplied to the user for use.

During working, the cold water enters the first cavity via the inlet 413 along the arrow direction, is heated and gasified, and then stored in the gas storage device 4331; at the time of needing to use the energy, the corresponding valve is opened to allow the water steam to enter the steam turbo-generator 4332; then power generation is enabled; after power generation, the air pressure and temperature of the steam will both drop; the steam in gas or liquid state enters the working medium recovery module 4333. The working medium recovery module 4333 may act as a water heater; when it is not needed to use, the deposited water may flow back into the first cavity; at this point, the first circulating system is turned into an enclosed system (the outlet 414 now acts as the first working medium inlet). When it is needed to use, hot water may be discharged along the arrow direction. In addition, when the temperature in the working medium recovery device 4333 is not enough, hotter water may be obtained directly from the first cavity via the outlet 414.

The conversion efficiency of a common photovoltaic panel will decrease over time, while for the system according to this embodiment, because the sunlight is repetitively utilized in the enclosed cavity, the light that cannot be converted into electric energy will be converted into heat energy, which is stored or continued to be converted; therefore, even the conversion efficiency of the photovoltaic panel decreases somewhat, it will not generate a material impact on the overall conversion efficiency; in this way, the system according to the present embodiment has a longer service life and a better stability.

The system according to the present embodiment may be used as a home solar system, which may simultaneously supply hot water and electric energy; besides, it may also store the energy, which facilitates sustainable utilization and solves the problem that the solar energy is susceptible to natural conditions.

### Embodiment 5

Fig. 7 shows another embodiment of a solar energy utilization system according to the present disclosure, comprising an enclosed solar energy utilization apparatus, and an enclosed first circulating system.

The structure of the enclosed solar energy utilization apparatus in this embodiment is substantially similar to that in Embodiment 2, comprising a first receiver 510, a light energy conversion element (not shown), a light reflection element (not shown), a light guide device 504, a light converging device 505, and a second receiver 520. The difference between the enclosed solar energy utilization apparatus in this embodiment and that in Embodiment 2 lies in that the light guide device 504 is hermetically fitted to a light inlet of the second cavity, causing the second cavity to be relatively enclosed.

The first circulating system comprises a first pipeline system (not shown) constituting a loop, at least one valve (shown), and a plurality of node devices. Besides the gas storage device 5531 and the steam turbine-generator 5332 similar to those in Embodiment 4, the types of the node devices in this embodiment further comprise a supercharging device 5334. An upstream of the supercharging device is connected with a downstream of the steam turbo-generator via the first pipeline system, and the downstream of the supercharging device is connected with the first working medium inlet 513 via the first pipeline system. In other embodiments, the working medium recovery device may be first provided downstream of the steam turbo-generator, and then the supercharging device is provided downstream of the working medium recovery device.

The working manner of the system in this embodiment is similar to that in Embodiment 4, except that the gas or liquid out of the steam turbo-generator flows back into the first cavity after being supercharged by the supercharging device and then turns into steam again to flow out of the outlet 515. The system in this embodiment will not supply hot water to the external; the liquid is recycled substantially without loss; therefore, the first working medium may also adopt a liquid with a relatively low boiling point such as Freon and alcohol, etc.

In this embodiment, the first receiver cannot directly receive light energy, but only receives the heat energy generated from the sunlight in the second receiver. Because the second receiver is enclosed in the first receiver, the light energy that is not converted by the second receiver into electric energy will be completely converted into heat energy and is sufficiently absorbed by the first receiver to turn into the energy gasified by the first working medium. Thermal insulation protection may be made at an external periphery of the first receiver and at the exterior of the first pipeline system so as to reduce diffusion of heat energy.

The system in this embodiment may substantially convert all solar light into electric energy, which has a low energy waste and substantially has no medium loss; therefore, it is suitable for scenarios having higher requirements on efficiency and reliability, e.g., for constructing a middle-and-small-scale distributed solar power station on for example a building top or a mountain top.

### Embodiment 6

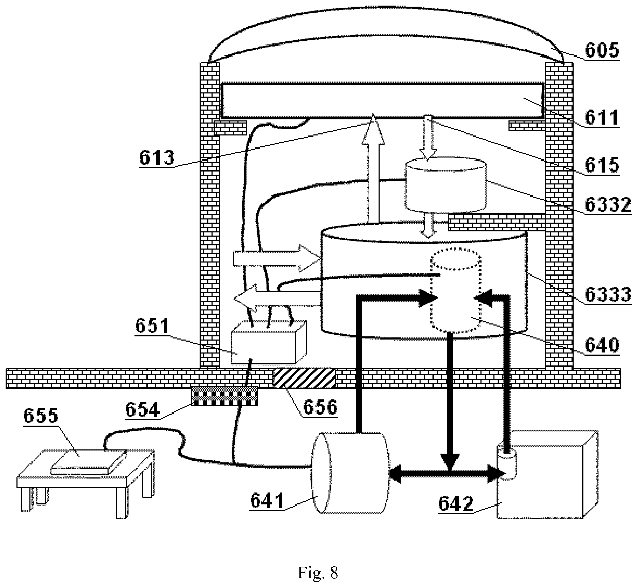

Fig. 8 shows another embodiment of a solar energy utilization system according to the present disclosure, comprising: an enclosed solar energy utilization apparatus, a first circulating system, a rechargeable battery 651, and a compressor 640.

The enclosed solar energy utilization apparatus in this embodiment may adopt a structure similar to that in Embodiment 1 or Embodiment 2, comprising a first cavity 611 and a light converging device 605 (the remaining components are not shown in the figure). The light converging device 605 may form a roof of a building, for example, in a form of light converging tiles. If the space size is relatively small such that the sunlight collected at one roof is insufficient, a light converging device may also be mounted on other roofs (not shown in the figure) to further guide the sunlight into the first cavity through a light guide tube.

The first circulating system is an open circulating system, which is similar to the first circulating system in Embodiment 4, except that the energy is stored using the rechargeable battery 651; therefore, a gas storage device is omitted in the node devices such that the water steam outlet 615 is directly connected with the steam turbo-generator 6332. The working medium recovery device 6333 acts as a water heater, as shown in the arrow, which, on one hand, receives cold water from the external and supplies the cold water to the first cavity via the inlet 613; on the other hand, it supplies hot water to the external.

The rechargeable battery 651 stores the electric energy generated by the enclosed solar energy utilization apparatus and the steam turbo-generator, and supply the electric energy to various power appliances for use, e.g., the controller 654 of the entire system, the compressor 640, an air supply device of an air-conditioner 6410, and an electric furnace 655, etc.

The compressor 640 is configured for being externally connected to an enclosed circulating system so as to compress a third working medium used by the circulating system. The enclosed circulating system using the third working medium may be a circulating system including a heat exchange device of the air conditioner 641 and a heat exchange device of a refrigerator 642.

The compressor 640 is at least partially disposed inside the working medium recovery device, causing the third working medium, when being compressed, to perform heat exchange with the first working medium in the working medium recovery device.

At present, conventional layouts of common energy consuming appliances used at home are unreasonable, which causes energy waste. For example, in summer, air-conditioners need to consume electric energy to dissipate heat to the outdoor, while refrigerators and water heaters will generate heat indoors when working, and these heats will undoubtedly aggravate the load of air-conditioner refrigeration. However, in winter, it is also desired to increase the heat indoors. These problems may be solved with cooperation between the system in this embodiment and a house structure.

For example, the system in this embodiment may be disposed on an attic of a house, and a heat insulation door or window 656 that is openable is provided between the attic and the indoor. At daytime, electric energy and high-temperature water steam are generated inside the first cavity; the high-temperature water steam propels the steam turbo-generator 6332 to generate power and then turn into hot water to be stored in the water heater 6333. When refrigeration is required, the compressor starts to compress the third working medium (e.g., a refrigerant, air, etc.); the generated heat is absorbed by cold water in the water heater; the compressed third working medium enters the heat exchange device of an indoor air-conditioner or the heat exchange device of the refrigerator through a closed loop, and flows back into the compressor after being expanded and absorbing heat. The compressor may also maintain a continuous switch-on, and store the compressed third working medium into a compression tank, such that when refrigeration is required, the compressed third working medium will be released. At night, the solar energy utilization apparatus will not work, and the water heater, the rechargeable battery, and the compression tank may continue supplying energy. In winter, by opening the heat insulation door 656, the heat generated by the system may be supplied indoors, reducing the heating demands indoors.

In this embodiment, by arranging compressors in a centralized fashion, the heat energy generated thereby is sufficiently utilized, which avoids energy waste; on the other hand, it is unnecessary to configure additional compressors to various indoor refrigerating devices separately, which not only reduces equipment costs, but also improves energy utilization. For example, for a refrigerator, it is only required to refrigerate, without other requirements (e.g., internal lighting), or even without a power supply requirement. Of course, if the house does not have an attic, the system in this embodiment may be disposed in other independent small space outdoors, which only requires disposing the light converging device on the roof.

### Embodiment 7

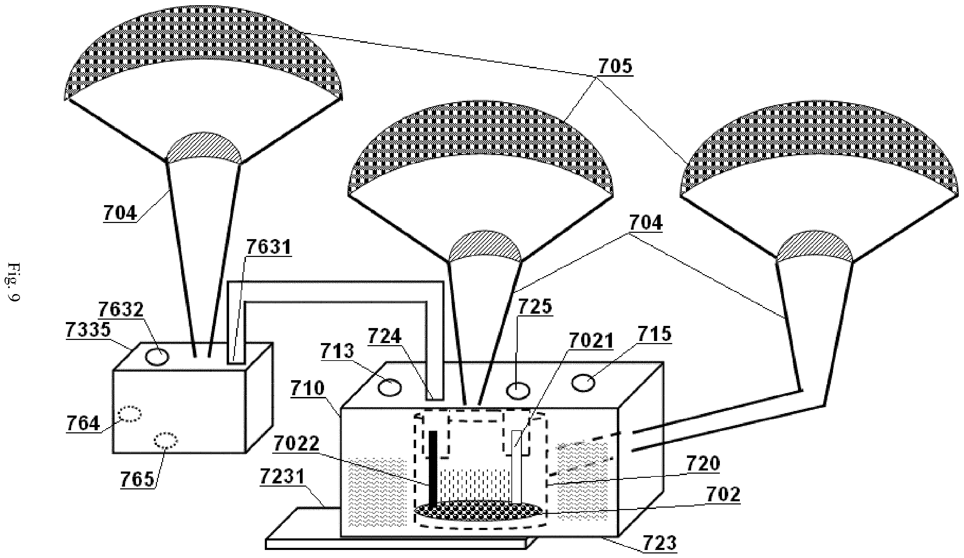

Fig. 9 shows another embodiment of a solar energy utilization system according to the present disclosure, comprising: an enclosed solar energy utilization apparatus, a first circulating system (not shown), and a second circulating system.

The enclosed solar energy utilization apparatus in this embodiment has a structure substantially similar to that of Embodiment 3, comprising a first receiver 710, a photovoltaic panel 702, a light reflection element (not shown), light guide devices 704, a light converging device 705, and a second receiver 720. Two light guide devices 704 guide externally collected sunlight into the second cavity through two light inlets (not shown) of the first cavity.

The first receiver 710 is connected with the first circulating system through a first working medium inlet 710 and a first product outlet 715. The first circulating system for example may adopt an open or enclosed circulating system similar to that in Embodiment 4 or 5.

The second working medium is fresh water or seal water, which may enter the second cavity from the openable opening 723; the openable opening 723 may be closed or opened through an openable door 7231. The second cavity is further provided with an anode 7021 and a cathode 7022 that are electrically connected with a photovoltaic panel 702. The anode and cathode are used for electrolyzing water (or water steam) to generate oxygen at the anode and hydrogen at the cathode; therefore, two second product outlets are provided, which are a hydrogen outlet 724 and an oxygen outlet 725, respectively. In other embodiments, the electrolysis may also be performed in the first cavity; or, after the water steam is led out from the second cavity (or the first cavity), it is electrolyzed in its storage device. Based on the current technologies, the efficiency of electrolyzing high-temperature water steam is higher than that of electrolyzing cold water. However, things might change with technology development, and the electrolysis operation may be performed at an appropriate procedure as needed. The oxygen generated from the electrolysis may be supplied into a gas tank to form an industrial oxygen bottle, or discharged into air after power generation by the steam turbo-generator. The hydrogen generated by electrolysis may be compressed by the compressor and then stored as fuels for a fuel battery or an internal combustion engine. However, in this embodiment, it will be used for generating a further storable energy source.

The second circulating system is an open circulating system. Node devices of the second circulating system include a reaction furnace 7335 that has at least two gas inlets and at least one product outlet. One gas inlet 7631 of the reaction furnace is connected with a hydrogen outlet 724 via a second pipeline system, and the other gas inlet 7632 of the reaction furnace is configured for being supplied with gas containing carbon dioxide, e.g., air. In the reaction furnace, the carbon dioxide and the hydrogen react at high temperature to generate methane (CH₄) and water. A product outlet 764 of the reaction furnace is configured for allowing the methane generated from the reaction to leave the reaction furnace, while the other product outlet 765 is configured for discharging fresh water. As a preferred embodiment, the high-temperature methane gas flowing out of the outlet 764 may be stored after passing through a safe (spark-free) steam turbo-generator, thereby achieving dual effects of power generation and cooling.

In this embodiment, the reaction furnace obtains the high temperature required for reaction by solar energy converging and heating, while in other embodiments, a manner of fully electrical heating or auxiliary electrical heating may also be adopted.

The system in this embodiment is suitable for a large-scale solar power station, which may not only fully utilize the solar energy, but also may realize rich functions, including: power generation, industrial oxygen production or sea water desalinization, and producing clean energies (e.g., hydrogen or methane, etc.) available for long-term storage utilizing solar energy, etc.

The principles and embodiments have been illustrated above through specific examples. It should be understood that the embodiments are intended only for facilitating understanding the present disclosure, rather than limiting the present disclosure. A person of normal skill in the art may vary the specific embodiments in accordance with ideas of the present disclosure.

## Claims

1. An enclosed solar energy utilization apparatus, comprising:
a first receiver that forms a relatively enclosed first cavity on which at least one light inlet is provided;
at least one light energy conversion element, or at least one light energy conversion element and at least one light reflection element, which is(are) provided on an inner wall of the first cavity or provided inside an internal space of the first cavity; and
at least one light guide device each being hermetically-fitted to the corresponding light inlet, for guiding externally collected sunlight to enter the first cavity via the light inlet.

2. The apparatus of claim 1, further comprising:
at least one light converging device for converging the sunlight to a light path inlet of the corresponding light guide device, the light converging device having at least one light converging refractive surface, the light converging refractive surface being a toothed surface and including at least one Fresnel unit.

3. The apparatus of claim 2, wherein,
a macroscopic surface of the toothed surface has a shape of a rotational curved surface or a coaxial plane; or,
the toothed surface is coated with a film for enhancing transmissivity.

4. The apparatus of claim 2, wherein the at least one light energy conversion element is a photovoltaic panel, and the light reflection element or light converging refractive surface has a metal coating film, the metal coating film being electrically connected with a negative pole of the photovoltaic panel.

5. The apparatus of claim 1, further comprising:
a divergent lens provided at the light inlet; or
a light exit direction of the light guide device is angled with a normal direction of the inner wall it faces.

6. The apparatus of claim 1, wherein
the light energy conversion element is provided inside an internal space of the first cavity; a support structure of the light energy conversion is formed into a stereoscopic shape; and the light energy conversion element is disposed on an outer surface of the support structure.

7. The apparatus of any one of claims 1-6, wherein
the first cavity is further provided with at least one working medium inlet for allowing a first working medium to enter the first cavity and at least one first product outlet for allowing a first product to leave the first cavity into an externally connected first circulating system, the first product being a substance obtained after at least part of energy from sunlight acts on the first working medium.

8. The apparatus of claim 7, wherein
at least one light energy conversion element is a photovoltaic panel, the apparatus further comprising one or more of the following:
an energy store electrically connected with the photovoltaic panel, for storing the electric energy; wherein the energy store is selected from a supercapacitor, a rechargeable battery, and an air compressor;
an alternative current inverter electrically connected with the photovoltaic panel, for converting a direct current outputted by the photovoltaic panel into an alternative current;
a state sensor and a state display, for sensing and displaying operating parameters of the apparatus, respectively, the operating parameters being selected from one or more of the following set: voltage, current, power, stock and temperature of the working medium in the cavity; and
a controller, for controlling a working state of the apparatus based on a sensing result of the state sensor.

9. The apparatus of any one of claims 1-8, further comprising:
a second receiver, which is formed as a second cavity on which at least one light inlet is provided; wherein
the second receiver is at least partially provided inside an internal space of the first cavity; and
the at least one light energy conversion element is provided on an inner wall of the second cavity or provided inside an internal space of the second cavity; and
the at least one light guide device is through the light inlet of the first cavity and hermetically-fitted with the light inlet of the second cavity, for guiding externally collected sunlight into the second cavity.

10. The apparatus of claim 9, wherein
the light guide device fitted with a light inlet of the second cavity is hermetically fitted with the light inlet of the second cavity, causing the second cavity relatively enclosed; and
the second cavity is further provided with at least one second working medium inlet for allowing a second working medium to enter the second cavity and at least one second product outlet for allowing the second product to leave the second cavity into the externally connected circulating system, the second product being a substance obtained after at least part of energy from sunlight acts on the first working medium.

11. The apparatus of claim 10, wherein
a first openable opening is also provided at a side face or a bottom portion of the first cavity, the first openable opening being sealable or openable through an openable door; or,
one first working medium inlet or one first product outlet is formed as the first openable opening; or,
a side face or a bottom portion of the second cavity is provided with a second openable opening; or,
one second working inlet or one first product outlet is formed as the second openable opening.

12. The apparatus of claim 10, wherein
the light conversion element or the light reflection element is laid out on an entire inner wall of the first cavity; or,
the light energy conversion element is laid out on an entire inner wall of the second cavity; or,
the light energy conversion element or the light reflection element is laid out on an entire outer wall of the second cavity; or,
the first working medium or the second working medium is selected from same or different kinds in a set of: fresh water, sea water, alcohol, refrigerant, liquid nitrogen.

13. A solar energy utilization system, comprising:
the enclosed solar energy utilization apparatus of claim 7, and
a first circulating system, which is an open or enclosed circulating system, comprising:
a first pipeline system that is at least connected with a first product outlet, or at least connected with a first working medium inlet and a first product outlet;
at least one valve for controlling switch-on and switch-off of a segment of pipeline in the first pipeline system; and
at least one node device connected into the first pipeline system, for storing, or for energy conversion, or for energy exchange.

14. The system of claim 13, wherein
the first working medium is a liquid, and the first product at least includes a gasified product of the first working medium;
types of the node devices include one or more selected from the following set: a gas storage module, a steam turbo-generator, and a working medium recovery module; and
the respective node devices are arranged from the first product outlet along a flow direction starting from the first product outlet in accordance with their sequence in the set.

15. The system of claim 14, wherein
types of the node devices further comprise a supercharging device, wherein an upstream of the supercharging device is connected with a downstream of the steam turbo-generator via the first pipeline system, and the downstream of the supercharging device is connected with the first working medium inlet via the first pipeline system.

16. The system of claim 14, further comprising:
a compressor externally connected to an enclosed circulating system, for compressing a third working medium used by the circulating system; and
the compressor is at least partially disposed inside the working medium recovery device, causing the third working medium, when being compressed, to perform heat exchange with the first working medium in the working medium recovery device.

17. A solar energy utilization system, comprising:
the enclosed solar energy utilization apparatus of claim 10;
a first circulating system which is an open or enclosed circulating system, comprising:
a first pipeline system that is at least connected with a first product outlet, or at least connected with a first working medium inlet and a first product outlet;
at least one valve for controlling switch-on and switch-off of a segment of pipeline in the first pipeline system; and
at least one node device, the node device of the first circulating system being connected into the first pipeline system, for storing, or for energy conversion, or for energy exchange; and
a second circulating system which is an open or enclosed circulating system, comprising:
a second pipeline system that is at least connected with a second product outlet, or at least connected with the second working medium inlet and the second product outlet;
at least one valve configured for controlling switch-on and switch-off of a segment of pipeline in the second pipeline system; and
at least one node device, the node device of the second circulating system being connected into the second pipeline system, for storing, or for energy conversion, or for energy exchange.

18. The apparatus of claim 17, wherein
the second working medium is fresh water or sea water,
at least one light energy conversion element in the second cavity is a photoelectric conversion element; the second cavity is further provided with an anode and a cathode that are electrically connected with the photoelectric conversion element; and the anode and cathode are used for electrolyzing water to generate oxygen at the anode and hydrogen at the cathode; and
two second product outlets are provided, which are a hydrogen outlet and an oxygen outlet, respectively.

19. The apparatus of claim 18, wherein
node devices of the second circulating system include a reaction furnace that has at least two gas inlets and at least one product outlet;
one gas inlet of the reaction furnace is connected with the hydrogen outlet via the second pipeline system, and the other gas inlet of the reaction furnace is configured for being supplied with gas containing carbon dioxide;
the reaction furnace is configured for causing the carbon dioxide and the hydrogen to react by solar energy converging heating or electrically heating to produce methane and water, and
at least one product outlet of the reaction furnace is configured for causing the methane generated from the reaction to leave the reaction furnace.
